# EUROPÄISCHE PATENTSCHRIFT

(11) **EP 3 069 162 B1**
(45) Veröffentlichungstag und Bekanntmachung des Hinweises auf die Patenterteilung: **25.10.2023**
(21) Anmeldenummer: 14812124.7
(22) Anmeldetag: 11.11.2014
(51) Int. Cl.: G01S 13/38, G01S 13/88, F15B 15/28

(54) **MESSVORRICHTUNG ZUR ERMITTLUNG EINES ABSTANDES IN EINER LEITUNGSSTRUKTUR**
MEASURING DEVICE FOR DETERMINING A DISTANCE IN A CONDUCTING STRUCTURE
DISPOSITIF DE MESURE PERMETTANT DE DÉTERMINER UNE DISTANCE DANS UNE STRUCTURE CONDUCTRICE

(30) Priorität: 11.11.2013 DE 102013018808
(43) Veröffentlichungstag der Anmeldung: 21.09.2016
(73) Patentinhaber: Astyx GmbH, 85521 Ottobrunn (DE)
(72) Erfinder: GIERE, Andre, 85667 Oberpframmern (DE); LÜTTICH, Sebastian, 82515 Wolfratshausen (DE)
(74) Vertreter: Fish & Richardson P.C.
(86) Internationale Anmeldenummer: PCT/EP2014/003023
(87) Internationale Veröffentlichungsnummer: WO 2015/067378

(56) Entgegenhaltungen:
- DE-A1-102006 052 790
- DE-A1-102007 020 046
- DE-A1-102009 055 363
- DE-A1-102009 055 445
- US-A- 4 757 745

## Beschreibung

Die vorliegende Erfindung betrifft eine Abstandsmessvorrichtung zur Ermittlung eines Abstandes zwischen einem Reflektionskörper in einer Leitungsstruktur und einem an einem Endabschnitt der Leitungsstruktur vorgesehenen Einkopplungsbereich für elektromagnetische Wellen sowie entsprechende Verfahren zur Ermittlung des Abstands gemäß den Oberbegriffen der Ansprüche 1, 6 und 10.

Herkömmliche Abstandsmessvorrichtungen werden beispielsweise zur Detektion der Kolbenposition von Linearantrieben mit pneumatischen oder hydraulischen Zylindern eingesetzt. Die Kolbenpositionserfassung an Zylindern kann sowohl diskret, d. h. an diskreten Stellen, als auch kontinuierlich, d.h. ständig während des Betriebs, erfolgen.

Die diskrete Kolbenpositionsbestimmung wird in der Regel benötigt, um die Ausführung bzw. Beendigung einer Kolbenbewegung an eine Ablaufsteuerung, beispielsweise eine speicherprogrammierbarer Steuerungstechnik (SPS) zurückzumelden, um somit beispielsweise den nächsten Ablaufschritt einleiten zu können. Hierzu werden überwiegend magnetfeldempfindliche Sensoren bzw. Sensoreinrichtungen verwendet, welche das Magnetfeld eines Permanentmagneten, der sich an dem Zylinderkolben befindet, detektieren. Diese Art von Sensoren sind überwiegend als magnetfeldempfindliche Sensoren ausgeführt und sind als Reed-Schalter, magnetoresistive (MR), giant magnetoresistive (GMR) Schalter, Hall-Schalter oder magnetinduktive Näherungsschalter bekannt. Die dabei eingesetzten Sensoren werden extern an das Zylinderrohr des Kolbenzylinders montiert. Bewegt sich der Kolben in den Erfassungsbereich eines solchen Sensors, so erkennt dieser die Anwesenheit des Zylinderkolbens durch das Zylinderrohr hindurch.

Soll hingegen eine andere Position detektiert werden, so muss der Sensor mechanisch entsprechend justiert werden. Für jede zusätzlich zu erfassende Position muss folglich ein weiterer Sensor montiert werden, und zwar mit den damit verbundenen zusätzlichen Material-, Montage-, Justage- und Installationskosten. Dies geschieht in der Regel vor Ort beim Kunden. Oft ist dabei der Zylinder bereits in eine schwer zugängliche Maschine eingebaut und die Einstellung der Schaltabstände durch mechanisches Verschieben der extern montierten Magnetschalter ist nicht mehr möglich.

Ferner wird für diese extern angebauten Sensoren zusätzlich Einbauraum benötigt. Damit die Zugänglichkeit und Robustheit des Sensors gewährleistet werden kann, ist häufig erhöhter konstruktiver Aufwand erforderlich. Die externe Montage der Sensoren ist nicht zufrieden stellend, da diese durch Fremdeinwirkung von außen zerstört werden könnten. Die Befestigung der am Zylinder montierten Sensoren könnte zerbrechen und die Sensoren zu Boden fallen. Eine Fehlermeldung und ein Stillstand des Fertigungsbands wären die Folge. 50% aller Ausfälle bei pneumatischen Antrieben ereignen sich auf oben genannte Art und Weise.

Zur kontinuierlichen Kolbenpositionsmessung werden gewöhnlich Meßsysteme verwendet, die potentiometrisch, magnetostriktiv oder nach dem LVDT-Prinzip (Linear Variable Differential Transformer) arbeiten. Die Kolbenposition wird bei diesen Systemen kontinuierlich und überwiegend als analoges Spannungssignal ausgegeben. Sensoren nach dem LVDT-Prinzip benötigen beim Einschalten immer eine Referenzfahrt. Als Ergänzung zu diesen Systemen sind auch inkrementelle Wegmessungen bekannt. Diese Systeme werden beispielsweise durch die magnetische Kodierung der Kolbenstange realisiert und können somit nur zur relativen Wegmessung verwendet werden. Zudem werden beim Ausfahren der Kolbenstange vorhandene Metallspäne angezogen, die dann beim Einfahren der Kolbenstange die Dichtung zerstören. Magnetostriktive und potentiometrische Wegmesssysteme werden extern oder in der hohl zu bohrenden Kolbenstange montiert. Die hohle Kolbenstange schwächt den Antrieb und die externe Montage verursacht einen erheblichen logistischen Aufwand.

Sowohl die kontinuierliche als auch die diskrete Kolbenpositionsbestimmung können nicht oder nur mit erheblichem konstruktiven Aufwand und den dadurch verbundenen hohen Kosten in einen Zylinder integriert werden. Der erhebliche konstruktive Aufwand ist dadurch begründet, dass alle beschriebenen gängigen Sensorprinzipien auf die entsprechende Zylinderlänge angepasst werden müssen, da sie einen zu kurzen Erfassungsbereich besitzen.

DE 10 2009 055 445 A1 beschreibt eine Vorrichtung gemäß dem Oberbegriff des Anspruchs 1.

Die Druckschrift EP 1 040 316 beschreibt die Vorrichtung und das Verfahren zur Abstandsbestimmung in einer Leitungsstruktur unter quasi statischen dielektrischen Eigenschaften des Mediums in der Leitungsstruktur. Bei einer Temperaturschwankung und oder Druckschwankung des Mediums kann es je nach Anwendungsfeld und Medium zu einer stärkeren Änderung der dielektrischen Eigenschaften des Mediums in der Leitungsstruktur kommen, wodurch die Abstandsbestimmung ungenauer werden kann.

Weitere Ursachen für eine Änderung der dielektrischen Eigenschaften des Mediums in der Leitungsstruktur können u.a. Verschmutzung, Luftblasen, Wasser im Medium oder Wechsel des Mediums sein.

Daher wird die Messgenauigkeit des Systems zur Abstandsbestimmung in den vorher genannten Fällen wesentlich durch die zum Messzeitpunkt vorherrschenden dielektrischen Eigenschaften des Mediums bestimmt, welche jedoch nachteilig bei der Auswertung selten berücksichtigt wurden.

Der vorliegenden Erfindung liegt somit die Aufgabe zugrunde, eine geeignete, einfache Vorrichtung sowie ein entsprechendes Verfahren bereitzustellen, welche die o.g. Nachteile überwinden und die dielektrischen Eigenschaften des Mediums messtechnisch in einfacher Weise berücksichtigen und eine hohe Präzision der Abstandsbestimmung gewährleisten.

Diese Aufgabe wird vorrichtungsseitig durch die Merkmale gemäß Anspruch 1 und verfahrensseitig durch die Merkmale gemäß Anspruch 6 und 10 gelöst.

Ein wesentlicher Aspekt vorliegender Erfindung besteht darin, dass die Abstandsmessvorrichtung zur Ermittlung eines Abstandes zwischen einem Reflektionskörper in einer Leitungsstruktur und einem an einem Endabschnitt der Leitungsstruktur vorgesehenen Einkopplungsbereich für elektromagnetische Wellen eine Sende- und Empfangseinrichtung und einem am Einkopplungsbereich vorgesehenen Leitungsübergang zur Kopplung der Sende- und Empfangseinrichtung mit der ein Medium enthaltene Leitungsstruktur aufweist, um eine elektromagnetische Welle in die Leitungsstruktur einzukoppeln und die am Reflektionskörper reflektierte elektromagnetische Welle aus der Leitungsstruktur auszukoppeln, und eine Auswerteeinrichtung zur Ermittlung des Abstands zwischen dem Einkopplungsbereich und dem Reflektionskörper aus dem komplexen Reflektionsfaktor zwischen der eingekoppelten elektromagnetischen Welle und der ausgekoppelten elektromagnetischen Welle.

Die physikalischen Eigenschaften des Mediums bestimmen dabei maßgeblich die Wellenlänge in der Leitungsstruktur, so dass deren Berücksichtigung den technischen Vorteil der Erfindung bedingt. Die erfindungsgemäße Abstandsmessvorrichtung ermöglicht somit vorteilhaft eine kontinuierliche, absolute Abstandsmessung mit einer besonders hohen Genauigkeit und bietet die Möglichkeit zur vollständigen Integration der Sende- und Empfangseinrichtung und der Auswerteelektronik im Zylinderdeckel, d.h. es gibt keine extern zu montierenden Teile. Des Weiteren ist keine mechanische Änderung der pneumatisch relevanten Teile des Zylinders, beispielsweise des Kolbens, der Endlagendämpfung, der Kolbenstange oder der Luftzuführung, erforderlich. Zudem sind keine weiteren externen oder über die Erfindung hinaus gehenden Komponenten zur Bestimmung der dielektrischen Eigenschaften des Mediums notwendig. Dieses schließt auch Druck- und Temperatursensoren mit ein, über die indirekt die dielektrischen Eigenschaften abgeschätzt werden könnten. Die Schaltabstände beim Erreichen von bestimmten Positionen sollen extern über eine elektronische Schnittstelle einstellbar sein ("Teach-in"-Fähigkeit). Ein einfacher, universell einsetzbarer Sensor bildet unabhängig von der Zylinderlänge die Sende- und Empfangseinrichtung (X-Längenfähigkeit).

Weitergehende vorteilhafte Ausgestaltungen sind Gegenstand der Unteransprüche.

Gemäß Anspruch 1 ist eine Messleitung zur Materialeigenschaftsdetektion des Mediums in dem Einkopplungsbereich in die Leitungsstruktur zur Abstandsbestimmung vorgesehen. Vorzugsweise ist die Messleitung eine TEM Leitung, wie zum Beispiel eine Koaxialleitung.

Die Bereitstellung einer Messleitung zur Materialeigenschaftsdetektion und deren Platzierung im Bereich der Einkopplung in die Leitungsstruktur bietet wesentliche Vorteile gegenüber den Abstandsmessvorrichtungen aus dem Stand der Technik. Die Messleitung und deren Platzierung ermöglicht vorteilhaft insbesondere eine direkte Bestimmung der dielektrischen Eigenschaften des Mediums, welche für eine hochgenaue Abstandsbestimmung notwendig sind. Dies ist besonders bei Medien mit einer starken Schwankung der dielektrischen Eigenschaften in Abhängigkeit von beispielsweise Druck, Temperatur, Alterung und/oder Verunreinigung zur Erschließung von Anwendungen, bei denen diese Faktoren relevant sind, notwendig.

Vorzugsweise wird die Abstandsmessvorrichtung bzw. die Messleitung zur Materialeigenschaftsdetektion in Transmission betrieben und ist über eine Einkopplungsstruktur mit einem HF-Transmitter auf der Auswerteelektronik verbunden, und über eine Auskoppelstruktur mit einem HF-Receiver auf der Auswerteelektronik verbunden ist. Die Verwendung einer Messleitung in Transmission ermöglicht vorteilhaft einen einfachen Aufbau der Signalverarbeitungskette zur Ein- und Auskopplung der Energie in die Messleitung, da hier im Gegensatz zur Reflektion weniger Komponenten auf der Leiterplatte benötigt werden, insbesondere kein Richtkoppler.

Alternativ wird die Abstandsmessvorrichtung bzw. die Messleitung zur Materialeigenschaftsdetektion in Reflektion betrieben und ist über einen Richtkoppler mit einem HF-Transmitter und einem HF-Receiver auf der Auswerteelektronik verbunden, wobei die Reflektionsstelle der Messleitung analytisch beschrieben werden kann wie zum Beispiel als offenes Leitungsende. Hierbei ist die mechanische Integration der Messleitung in Reflektion wesentlich einfacher, da es hier nur eine Koppelstruktur gibt, die die Energie von der Leiterplatte in die Leitungsstruktur koppelt. Dieser Übergang ist, da er auf einer Seite im Medium liegt, welches Druck- und/oder Temperatur-Schwankungen unterliegt, mit erhöhtem mechanischem Aufwand verbunden.

Die Abstandsmessvorrichtung weist eine Auswerteelektronik und eine Sensoreinrichtung auf, die mit Hilfe eines oder mit der Kombination der beiden im Folgenden beschriebenen Verfahren die veränderlichen Umweltbedingungen in Form der dielektrischen Eigenschaften direkt erfassen kann und diese Information für eine genaue Abstandsbestimmung heranzieht.

Durch den Anspruch 6 wird ein erfindungsgemäßes Verfahren zur Ermittlung eines Abstands, insbesondere unter Verwendung einer Abstandsmessvorrichtung zwischen einem Reflexionskörper in einer ein Medium aufweisenden Leitungsstruktur und einem an einem Endabschnitt der Leitungsstruktur vorgesehenen Einkopplungsbereich für elektromagnetische Wellen bereitgestellt.

Somit wird ein Verfahren bereitgestellt, mit dem die Länge der Leitungsstruktur bis zum Reflektionsziel bei veränderlichen dielektrischen Eigenschaften des in der Leitungsstruktur enthaltenden Mediums gemessen wird. Das entsprechend dem Verfahren bereitgestellte Sendesignal wird in eine Leitungsstruktur eingespeist, am Reflexionsziel reflektiert und über das Einspeisesystem wieder empfangen. Dadurch wird die Messung des Abstandes zwischen dem Einkopplungspunkt und dem Reflexionsziel durchgeführt. Die Bestimmung der dielektrischen Eigenschaften erfolgt erfindungsgemäß entweder durch eine zusätzliche Leitungsstruktur oder, alternativ, unter Berücksichtigung der dispersiven Leitungseigenschaften.

Der zu messende Abstand erfolgt gemäß erstem Aspekt durch Messung der Phasendifferenz zwischen Sende- und Empfangssignal bei unterschiedlichen Frequenzen der elektromagnetischen Welle. Die Berücksichtigung der dielektrischen Eigenschaften zu Beginn des Verfahrens gewährleistet deren direkte Verwendung in dem folgenden Algorithmus. Durch Berücksichtigung der elektrischen Längen in der Leitungsstruktur auf Basis der ermittelten dielektrischen Eigenschaften wird eine wesentliche Verbesserung der Abstandsgenauigkeit ermöglicht. Zudem wird insbesondere bei Medien mit einer sehr großen Schwankung der dielektrischen Eigenschaften erst hierdurch eine Auswertung der Leitungslänge möglich.

Ein weiteres denkbares Verfahren zur Bestimmung der relativen Permittivität des Mediums auf Basis der gemessenen elektrischen Länge der Messleitung erfolgt durch Betrachtung der Phasendifferenz der gemessenen Phase zu einer Referenzmessung oder einem analytischen Modell der Messleitung inklusive der elektrischen Längen der Zuleitungen und notwendigen passiven Bauelemente.

Durch die Betrachtung der Phasendifferenz in einer Referenzmessung, bei der die dielektrischen Eigenschaften bekannt sind, oder in einem analytischen Modell der Messleitung inklusive der Zuleitungen ist vorteilhaft eine genauere Bestimmung der dielektrischen Eigenschaften möglich.

Ein weiteres alternatives erfindungsgemäßes Verfahren zur Ermittlung eines Abstands zwischen einem Reflexionskörper in einer Leitungsstruktur und einem an einem Endabschnitt der Leitungsstruktur vorgesehenen Einkopplungsbereich für elektromagnetische Wellen wird durch den Anspruch 10 bereitgestellt.

Dabei ermöglicht die Verwendung eines S-Parameter Blockes, der die Komponenten vor der Einkopplung in die Leitungsstruktur repräsentiert, die Extraktion eines S-Parameter Blockes, welcher nur die Leitungsstruktur beschreibt. Mittels dieses extrahierten S-Parameter Blocks lässt sich eine Phase bestimmen, die sich für eine bestimmte Frequenz linear mit der Leitungslänge entwickelt, während sich die gemessene Phase ohne Berücksichtigung des Einflusses der Komponenten vor der Einkopplung nicht linear mit der Leitungslänge entwickelt. Die lineare Entwicklung der Phase ist somit maßgeblich für eine hochgenaue Abstandsbestimmung notwendig.

Bevorzugt weist dieses Verfahren ferner folgenden Schritt auf:
Extrahieren mit dem gemessenen komplexen Reflektionsfaktors den S-Parameter Block, der die Messleitung zur Abstandsmessung repräsentiert, durch De-embedden des S-Parameter Blockes, der die aktiven und passiven Komponenten vor der Einkopplung und nach der Auskopplung der elektromagnetischen Welle repräsentiert.

Durch die Extraktion des S-Parameter Blocks, der die reine Messleitung repräsentiert, ist vorteilhaft eine direkte Bestimmung der Eigenschaften des Mediums möglich. Die hieraus folgende Bestimmung der dielektrischen Eigenschaften des Mediums kann dabei weiterhin beispielsweise temperaturveränderliche Einflüsse auf der Leiterplatte berücksichtigen.

Weiter bevorzugt weist das Verfahren zusätzlich folgenden Schritt auf:
Ermitteln der dielektrischen Eigenschaften des Mediums, insbesondere der relativen Permittivität aus dem von den dielektrischen Eigenschaften abhängigen dispersiven Frequenzverhalten der Wellenlänge in der Leitungsstruktur mit Hilfe eines extrahierten S-Parameter Blocks der Komponenten vor und zur Einkopplung in die Leitungsstruktur und unter Berücksichtigung einer um n*2*PI mehrdeutigen Phase des extrahierten S-Parameter Blockes.

Die Verwendung der dielektrischen Eigenschaften des Mediums erweist sich auch in dieser Ausführung zur Abstandsermittlung als vorteilhaft.

Weiter bevorzugt wird bei diesem Verfahren die relative Permittivität des Mediums in der Leitungsstruktur mit Hilfe einer Messleitung zur Materialeigenschaftsdetektion ermittelt.

Beide Verfahrensalternativen stehen vorzugsweise bei der Ermittlung des Abstandes mit Hilfe der Phasendifferenz zwischen mehreren Frequenzen Informationen zur Phasendifferenz, dem Abstand und dem dielektrischen Eigenschaften durch eine Kalibrationsmessung und unter Verwendung eines zusätzlichen Messsystems als Bezugsgröße zur Verfügung.

Die Verwendung von mehreren Frequenzen ermöglicht dabei eine höhere Genauigkeit, da hier unkorrelierte Messfehler herausgemittelt werden können. Auch ermöglichen mehrere Frequenzen einen größeren Eindeutigkeitsbereich bei der Längenbestimmung der Leitungsstruktur.

In beiden Verfahrensalternativen wird weiterhin vorzugsweise die relative Permittivität bei größer/gleich einer Frequenz im Zeit- oder Frequenzduplexverfahren ermittelt und durch Mittelung der Ergebnisse bei unterschiedlichen Frequenzen präzisiert.

Die Verwendung von mehreren Frequenzen ermöglicht auch hier eine höhere Genauigkeit, da unkorrelierte Messfehler herausgemittelt werden können. Ebenfalls ermöglichen mehrere Frequenzen einen größeren Eindeutigkeitsbereich bei der Längenbestimmung der Leitungsstruktur. Zudem ist bei einem Zeitduplex-Verfahren vorteilhaft eine geringere Entkopplung zwischen der Messleitung und der Leitungsstruktur notwendig.

In beiden Verfahrensalternativen wird weiterhin vorzugsweise die Messleitung für die jeweils angeregten Frequenzen von der Leitungsstruktur zur Abstandsmessung entkoppelt. Vorteilhaft wird hierdurch eine höhere Genauigkeit erzielt, da die Energie in der Messleitung nicht über die Leitungsstruktur herauskoppelt.

In beiden Verfahrensalternativen wird weiterhin vorzugsweise der S-Parameter Block durch eine Parametersuche mit Hilfe einer Fehlerminimierung unter Modellierung einer idealen Messleitung zur Abstandsmessung, der Abstandsreferenzinformation und den Messwerten der Auswerteeinheit des komplexen Reflektionsfaktors für größer gleich 2 Messpositionen und größer gleich 2 Frequenzen bestimmt wird.

Der S-Parameterblock bezieht sich dabei auf jenen S-Parameterblock, welcher die aktiven und passiven Komponenten vor der Einkopplung und nach der Auskopplung der elektromagnetischen Welle repräsentiert.

Dieser Verfahrensaspekt ermöglicht eine schnelle und effektive Bestimmung des S-Parameterblocks der aktiven und passiven Komponenten vor der Einkopplung.

Weitere Vorteile, Merkmale und Anwendungsmöglichkeiten der vorliegenden Erfindung ergeben sich aus der folgenden Beschreibung bevorzugter Ausführungsbeispiele in Verbindung mit der Zeichnung. Dabei zeigen:
Fig. 1 in perspektivischer Darstellung eine herkömmliche Abstandsmessvorrichtung mit einem Leitungsübergang an einer als Zylinder ausgebildeten Leitungsstruktur;
Fig. 2 in perspektivischer Darstellung eine Ausführungsform der Abstandsmessvorrichtung mit einem Leitungsübergang an einem Zylinder und zusätzlich einer Leitung zur Materialeigenschaftsdetektion mit einem Einkoppel- und Auskoppelpunkt gemäß der Erfindung;
Fig. 3 das Hochfrequenz-Ersatzschaltbild einer Abstandsmessvorrichtung mit den wesentlichen Komponenten vor dem Leitungsübergang, die für die Permittivitätsbestimmung und Abstandsmessung deembedded werden müssen; Diese Vorrichtung entspricht nicht der Erfindung; und
Fig. 4 das Hochfrequenz-Ersatzschaltbild einer Ausführungsform der Abstandsmessvorrichtung mit den wesentlichen Komponenten vor dem Leitungsübergang inklusive der Komponenten für die Ankopplung der Leitung zur Materialdetektion, die für die Permittivitätsbestimmung und Abstandsmessung ausgebettet werden müssen. Dies ist eine Vorrichtung gemäß der Erfindung.

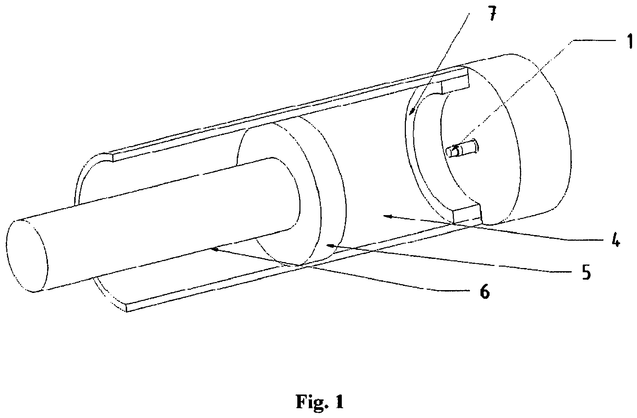

**Fig. 1** zeigt eine perspektivische vereinfachte Darstellung einer Abstandsmessvorrichtung mit einem Leitungsübergang als Modentransformator 1 für die Einkopplung der koaxialen Welle in eine Hohlleiterwelle im E01-Mode in die als Zylinder 4 ausgebildete Leitungsstruktur. Dargestellt ist auch ein mechanischer Kolbenanschlag 7, welcher insbesondere den Modentransformator 1 vor einem Zusammenstoß mit dem Kolben 5, hier betätigt durch die Kolbenstange 6, schützt.

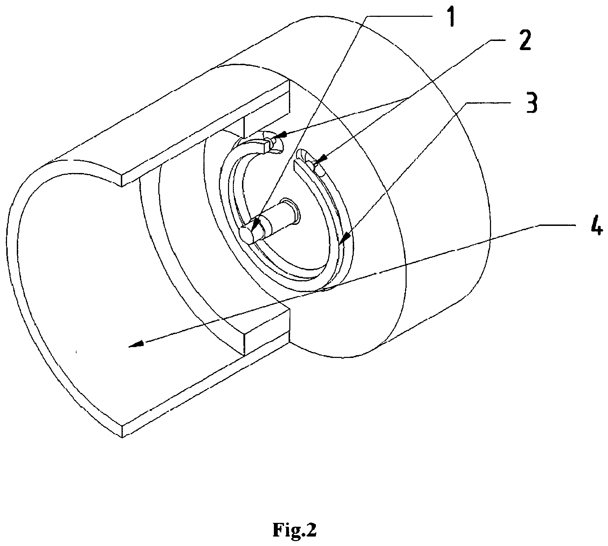

**Fig. 2** zeigt eine perspektivische vereinfachte Darstellung einer Ausführungsform des Endabschnitts eines Zylinders der Abstandsmessvorrichtung mit einem Leitungsübergang als Modentransformator 1 für die Einkopplung der koaxialen Welle in eine Hohlleiterwelle im E01-Mode in die Leitungsstruktur bzw. Zylinder 4 sowie einer in Transmission betriebenen Leitung zur Materialdetektion 3. Die geführte Welle in der Leitung zur Materialdetektion wird über die Ein- und Auskoppelpunkte 2 gespeist. Durch die Ausführungsform und Platzierung der Leitung zur Materialdetektion 3 ist eine hohe Entkopplung der beiden unterschiedlichen Einkoppelstrukturen 1, 3 gewährleistet.

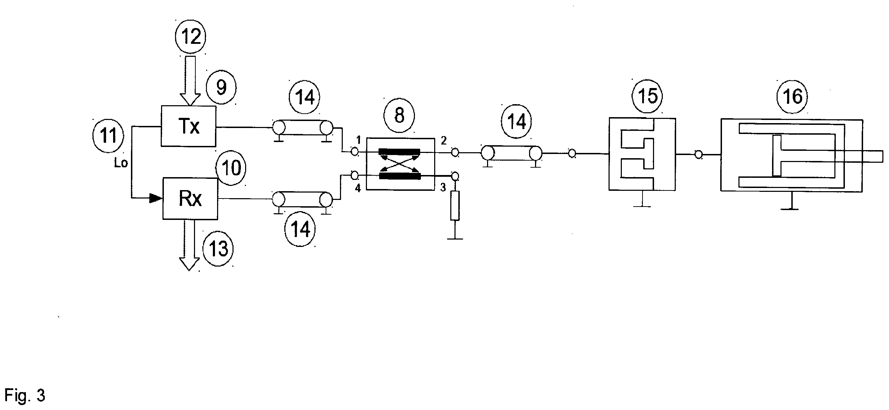

**Fig. 3** zeigt das Hochfrequenz-Ersatzschaltbild einer Abstandsmessvorrichtung mit den wesentlichen Komponenten vor dem Leitungsübergang 15. Gezeigt ist dabei der gesamte Signalpfad von der Signalerzeugung im HF-Transmitter 9, den Verbindungen auf der Leiterplatte 14, einem Richtkoppler 8 zur Transmission der Energie über weitere Verbindungen 14 an den Einkopplungspunkt 15 der Abstandsmessvorrichtung.

Nach dem Einkoppeln in die Leitungsstruktur 16 erfolgt die Wellenausbreitung in der dispersive Leitungsstruktur und der Reflektion in dem Kolben in einer Leitungsstruktur.

Die reflektierte Welle wird weiterhin mit der Einkoppelstruktur zur Modentransformation 15 weiter über eine Verbindung 14 an den Richtkoppler 8 geleitet, wo sie an den HF-Receiver 10 weitergeführt wird. Die Messung des komplexen Reflektionsfaktors erfolgt dabei an dem HF-Receiver 10 durch eine Phasensynchronisation über eine Lo-Leitung 11 vom HF-Transmitter 9.

Für die in der Erfindung beschriebenen Extraktion der dielektrischen Eigenschaften und der Abstandsmessung bei veränderlichen Umweltbedingungen sind hierbei die elektrischen Längen und Reflektionsfaktoren der Komponenten 8 (Richtkoppler), 9 (HF-Transmitter), 10 (HF-Receiver), 14 (Verbindung), 15 (Einkoppelstruktur zur Modentransformation) von dem gemessenen komplexen Reflektionsfaktor, bemessen am Ausgang des Receivers 13, zu de - embedden. Dieser de-embeddete komplexe Reflektionsfaktor beschreibt das elektrische Verhalten der Leitungsstruktur 16 zur Abstandsmessung und wird in dem Verfahren zur Permittivitäts- und Abstandsbestimmung nach Anspruch 10 herangezogen. Die Einstellung der unterschiedlichen Frequenzen erfolgt dabei durch ein Kontrollsignal 12 zum HF-Transmitter.

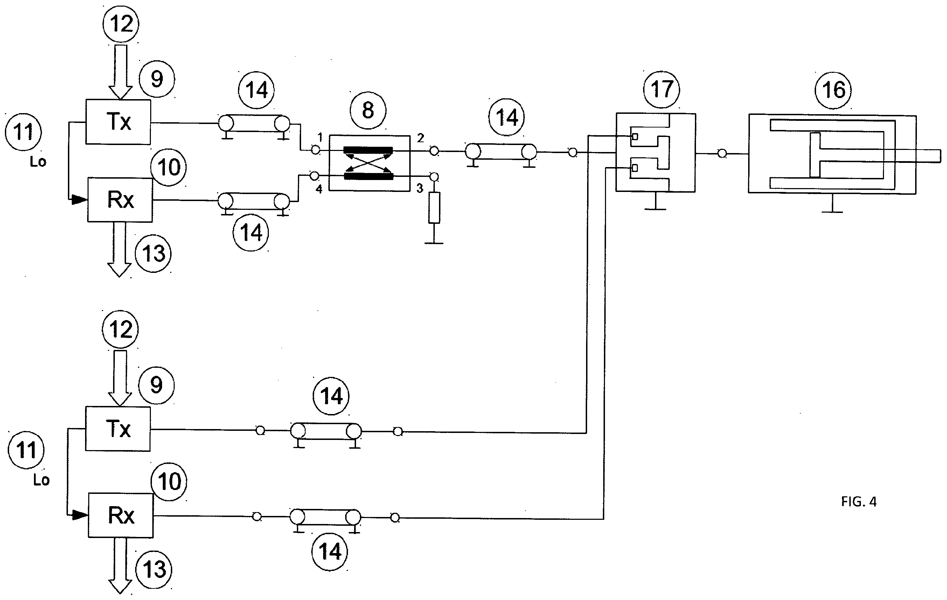

Fig. 4 zeigt das Hochfrequenz-Ersatzschaltbild einer Ausführungsform der Abstandsmessvorrichtung äquivalent zu Fig. 3, jedoch erweitert um die Komponenten, die zur Verwendung der Leitung zur Materialeigenschaftsdetektion notwendig sind. Für die Ausführung einer Transmissionsleitung zur Materialeigenschaftsdetektion ist hierbei der Signalpfad beginnend von einem zweiten HF Transmitter 9 über Verbindungen 14 zur Einkopplung an die Transmissionsleitung im Bereich des Einkopplungspunktes 17 der Abstandsmessvorrichtung gezeigt. Nach Auskopplung der Leitung zur Materialdetektion erfolgt die Anbindung eines zweiten HF Receivers 10.

## Patentansprüche

1. Abstandsmessvorrichtung zur Ermittlung eines Abstandes zwischen einem Reflektionskörper (5) in einer Leitungsstruktur (4) und einem an einem Endabschnitt der Leitungsstruktur vorgesehenen Einkopplungsbereich für elektromagnetische Wellen,
a) mit einer Sende- und Empfangseinrichtung und einem am Einkopplungsbereich vorgesehenen Leitungsübergang (1) zur Kopplung der Sende- und Empfangseinrichtung mit der ein Medium enthaltene Leitungsstruktur, um eine elektromagnetische Welle in die Leitungsstruktur einzukoppeln und die am Reflektionskörper reflektierte elektromagnetische Welle aus der Leitungsstruktur auszukoppeln, und
b) mit einer Auswerteeinrichtung zur Ermittlung des Abstands zwischen dem Einkopplungsbereich und dem Reflektionskörper aus dem komplexen Reflektionsfaktor zwischen der eingekoppelten elektromagnetischen Welle und der ausgekoppelten elektromagnetischen Welle, **gekennzeichnet durch**
c) eine in dem Einkopplungsbereich der Leitungsstruktur vorgesehene Messleitung (3) zur Materialeigenschaftsdetektion des Mediums, mit einem Einkoppel- und Auskoppelpunkt (2).

2. Abstandsmessvorrichtung nach Anspruch 1, **dadurch gekennzeichnet, dass** die Messleitung (3) eine TEM Leitung wie zum Beispiel eine Koaxialleitung ist.

3. Abstandsmessvorrichtung nach Anspruch 2, **dadurch gekennzeichnet, dass** die Messleitung (3) zur Materialeigenschaftsdetektion in Transmission betrieben wird und
a) über eine Einkoppelstruktur mit einem HF-Transmitter (9) auf der Auswerteelektronik verbunden ist, und
b) über eine Auskoppelstruktur mit einem HF-Receiver (10) auf der Auswerteelektronik verbunden ist.

4. Abstandsmessvorrichtung nach Anspruch 2, **dadurch gekennzeichnet, dass** die Messleitung (3) zur Materialeigenschaftsdetektion in Reflektion betrieben wird und
a) über einen Richtkoppler (8) mit einem HF-Transmitter (9) und einem HF- Receiver (10) auf der Auswerteelektronik verbunden ist, und
b) eine Reflektionsstelle der Messleitung (3) aufweist, die analytisch beschrieben wird, wie zum Beispiel ein offenes Leitungsende.

5. Abstandsmessvorrichtung nach Anspruch 3 oder 4, **dadurch gekennzeichnet, dass** über den mit der Messleitung (3) verbundenen HF-Receiver (10) und HF-Transmitter (9) die Phase gemessen wird, die der elektrischen Länge der Messleitung (3) inklusive der elektrischen Länge der Zuleitungen und passiven Bauelementen entspricht.

6. Verfahren zur Ermittlung eines Abstands unter Verwendung einer Abstandsmessvorrichtung zwischen einem Reflexionskörper (5) in einer ein Medium aufweisenden Leitungsstruktur (4) und einem an einem Endabschnitt der Leitungsstruktur vorgesehenen Einkopplungsbereich für elektromagnetische Wellen, welches folgende Verfahrensschritte aufweist:
a) Ermittlung der relativen Permittivität des Mediums in der Leitungsstruktur mit Hilfe einer Messleitung (3) zur Materialeigenschaftsdetektion des Mediums, wobei die Messleitung (3) in dem Einkopplungsbereich der Leitungsstruktur vorgesehen ist und einen Einkoppel- und Auskoppelpunkt (2) aufweist,
b) Einkopplung einer elektromagnetischen Welle in die Leitungsstruktur über einen Leitungsübergang (1) am Einkopplungsbereich,
c) Auskopplung der am Reflexionskörper reflektierten elektromagnetischen Welle aus der Leitungsstruktur über den Leitungsübergang (1), sowie
d) Ermittlung des Abstands zwischen dem Einkopplungsbereich und dem Reflexionskörper aus der Phasendifferenz zwischen Sende- und Empfangssignal und den zugehörigen elektrischen Längen in der Leitungsstruktur zwischen der eingekoppelten und der ausgekoppelten elektromagnetischen Welle.

7. Verfahren nach Anspruch 6, **dadurch gekennzeichnet, dass** bei der Ermittlung des Abstandes mit Hilfe der Phasendifferenz zwischen Sende- und Empfangssignal Informationen zur Phasendifferenz, dem Abstand und den dielektrischen Eigenschaften durch eine Kalibrationsmessung und unter Verwendung eines zusätzliches Messsystems als Bezugsgröße zur Verfügung stehen.

8. Verfahren nach Anspruch 6, **dadurch gekennzeichnet, dass** die relative Permittivität bei größer/gleich einer Frequenz im Zeit- oder Frequenzduplexverfahren ermittelt wird und durch Mittelung der Ergebnisse bei unterschiedlichen Frequenzen präzisiert wird.

9. Verfahren nach Anspruch 6, **dadurch gekennzeichnet, dass** die Messleitung (3) für die jeweils angeregten Frequenzen von der Leitungsstruktur zur Abstandsmessung entkoppelt wird.

10. Verfahren zur Ermittlung eines Abstands zwischen einem Reflexionskörper (5) in einer Leitungsstruktur (4) und einem an einem Endabschnitt der Leitungsstruktur vorgesehenen Einkopplungsbereich für elektromagnetische Wellen, mit den Verfahrensschritten:
a) Ermittlung der relativen Permittivität eines Mediums in der Leitungsstruktur mit Hilfe einer Messleitung (3) zur Materialeigenschaftsdetektion des Mediums, wobei die Messleitung (3) in dem Einkopplungsbereich der Leitungsstruktur vorgesehen ist und einen Einkoppel- und Auskoppelpunkt (2) aufweist,
b) Einkopplung einer elektromagnetischen Welle in die Leitungsstruktur über einen Leitungsübergang (1) am Einkopplungsbereich,
c) Auskopplung der am Reflexionskörper reflektierten elektromagnetischen Welle aus der Leitungsstruktur über den Leitungsübergang (1),
d) Messen der Phasen und Amplitudenbeziehung mit einer Auswerteelektronik und Bestimmen eines komplexen Reflektionsfaktors,
e) Ermittlung des Abstands zwischen dem Einkopplungsbereich und dem Reflexionskörper mit Hilfe der über die dielektrischen Eigenschaften bestimmten Wellenlängen der elektromagnetischen Welle in einer dispersiven Leitung und Phasenbeziehungen eines extrahierten S-Parameterblocks der Leitungsstruktur unter Berücksichtigung der n*2*PI Mehrdeutigkeit der Phase der elektromagnetischen Welle.

11. Verfahren nach Anspruch 10, welches ferner den Schritt aufweist: Extrahieren mit dem gemessenen komplexen Reflektionsfaktors den S-Parameter Block, wobei der S-Parameter Block eine Messleitung zur Abstandsmessung repräsentiert, durch De-embedden des S-Parameter Blockes, der aktive und passive Komponenten vor der Einkopplung und nach der Auskopplung der elektromagnetischen Welle repräsentiert.

12. Verfahren nach einem der Ansprüche 10 oder 11, welches ferner die Schritte aufweist:
Ermitteln von dielektrischen Eigenschaften eines Mediums, oder der relativen Permittivität aus dem von den dielektrischen Eigenschaften abhängigen dispersiven Frequenzverhalten der Wellenlänge in der Leitungsstruktur mit Hilfe eines extrahierten S-Parameter Blocks von Komponenten vor und zur Einkopplung in die Leitungsstruktur und unter Berücksichtigung einer um n^{∗}2^{∗}PI mehrdeutigen Phase des extrahierten S- Parameter Blockes.

13. Verfahren nach Anspruch 10, **dadurch gekennzeichnet, dass** der S-Parameter Block durch eine Parametersuche mit Hilfe einer Fehlerminimierung unter Modellierung einer idealen Messleitung zur Abstandsmessung, einer Abstandsreferenzinformation und den Messwerten der Auswerteeinheit des komplexen Reflektionsfaktors für größer/gleich 2 Messpositionen und größer/gleich 2 Frequenzen bestimmt wird.

## Claims

1. Distance measuring device for determining a distance between a reflective body (5) in a conducting structure (4) and an injection region for electromagnetic waves provided in an end section of the conducting structure,
a) having a transmitting and receiving device and a conducting junction (1) provided in the injection region for coupling the transmitting and receiving device to the conducting structure containing a medium, in order to couple an electromagnetic wave into the conducting structure and to couple the electromagnetic wave reflected at the reflective body out of the conducting structure, and
b) having an evaluation device for determining the distance between the injection region and the reflective body from the complex reflection factor between the electromagnetic wave coupled in and the electromagnetic wave coupled out,
**characterized by**
c) a measuring line (3) provided in the injection region of the conducting structure for detecting the material properties of the medium, having a coupling-in and a coupling-out point (2).

2. Distance measuring device according to Claim 1, **characterized in that** the measuring line (3) is a TEM line such as a coaxial line.

3. Distance measuring device according to Claim 2, **characterized in that** the measuring line (3) for detecting the material properties is operated in transmission, and
a) is coupled via a coupling-in structure to an HF transmitter (9) on the evaluation electronics, and
b) is connected via a coupling-out structure to an HF receiver (10) on the evaluation electronics.

4. Distance measuring device according to Claim 2, **characterized in that** the measuring line (3) for detecting the material properties is operated in reflection, and
a) is connected via a directional coupler (8) to an HF transmitter (9) and an HF receiver (10) on the evaluation electronics, and
b) has a reflection point of the measuring line (3) which is described analytically, such as an open line end.

5. Distance measuring device according to Claim 3 or 4, **characterized in that** the phase which corresponds to the electrical length of the measuring line (3) including the electrical length of the feed lines and passive components is measured via the HF receiver (10) and HF transmitter (9) connected to the measuring line (3).

6. Method for determining a distance between a reflective body (5) in a conducting structure (4) having a medium and an injection region for electromagnetic waves provided in an end section of the conducting structure by using a distance measuring device, which has the following method steps:
a) determining the relative permittivity of the medium in the conducting structure with the aid of a measuring line (3) for detecting the material properties of the medium, wherein the measuring line (3) is provided in the injection region of the conducting structure and has a coupling-in and a coupling-out point (2),
b) coupling an electromagnetic wave into the conducting structure via a conducting junction (1) in the injection region,
c) coupling the electromagnetic wave reflected at the reflective body out of the conducting structure via the conducting junction (1), and
d) determining the distance between the injection region and the reflective body from the phase difference between the transmitted and received signal and the associated electrical length in the conducting structure between the electromagnetic wave coupled in and that coupled out.

7. Method according to Claim 6, **characterized in that** when determining the distance with the aid of the phase difference between the transmitted and received signal, information relating to the phase difference, the distance and the dielectric properties is available as a reference variable through a calibration measurement and by using an additional measuring system.

8. Method according to Claim 6, **characterized in that** the relative permittivity at greater than/equal to a frequency is determined in the time or frequency duplex method and is refined by averaging the results at different frequencies.

9. Method according to Claim 6, **characterized in that** the measuring line (3) for the respective excited frequencies is decoupled from the conducting structure for the distance measurement.

10. Method for determining a distance between a reflective body (5) in a conducting structure (4) and an injection region for electromagnetic waves provided in an end section of the conducting structure, having the method steps:
a) determining the relative permittivity of a medium in the conducting structure with the aid of a measuring line (3) for detecting the material properties of the medium, wherein the measuring line (3) is provided in the injection region of the conducting structure and has a coupling-in and a coupling-out point (2),
b) coupling an electromagnetic wave into the conducting structure via a conducting junction (1) in the injection region,
c) coupling the electromagnetic wave reflected at the reflective body out of the conducting structure via the conducting junction (1),
d) measuring the phases and amplitude relationship by using evaluation electronics and determining a complex reflection factor,
e) determining the distance between the injection region and the reflective body with the aid of the wavelengths of the electromagnetic wave determined via the dielectric properties in a dispersive line and phase relationships of an extracted S-parameter block of the conducting structure while taking into account the n*2*pi ambiguity of the phase of the electromagnetic wave.

11. Method according to Claim 10, which further has the step: extracting the S-parameter block with the measured complex reflection factor, wherein the S-parameter block represents a measuring line for distance measurement, by extracting the S-parameter block, which represents active and passive components before coupling in and after coupling out the electromagnetic wave.

12. Method according to either of Claims 10 or 11, which further has the steps:
determining dielectric properties of a medium or the relative permittivity from the dispersive frequency response of the wavelength in the conducting structure, which depends on the dielectric properties, with the aid of an extracted S-parameter block of components before and for the injection into the conducting structure and while taking into account a phase of the extracted S-parameter block that is ambiguous by n*2*pi.

13. Method according to Claim 10, **characterized in that** the S-parameter block is determined by a parameter search with the aid of error minimization with the modelling of an ideal measuring line for the distance measurement, distance reference information and the measured values from the evaluation unit of the complex reflection factor for greater than/equal to 2 measuring positions and greater than/equal to 2 frequencies.

## Revendications

1. Dispositif de mesure de distance permettant d'établir une distance entre un corps réfléchissant (5) dans une structure conductrice (4) et une zone d'injection pour des ondes électromagnétiques, prévue à une partie d'extrémité de la structure conductrice, comprenant
a) un moyen émetteur-récepteur et une jonction de ligne (1) prévue à la zone d'injection pour coupler le moyen émetteur-récepteur à la structure conductrice contenant un milieu afin d'injecter une onde électromagnétique dans la structure conductrice et d'extraire de la structure conductrice l'onde électromagnétique réfléchie au niveau du corps réfléchissant, et
b) un moyen d'évaluation pour établir la distance entre la zone d'injection et le corps réfléchissant à partir du facteur de réflexion complexe entre l'onde électromagnétique injectée et l'onde électromagnétique extraite,
**caractérisé par**
c) une ligne de mesure (3) prévue dans la zone d'injection de la structure conductrice pour la détection des propriétés matérielles du milieu, comprenant un point d'injection et d'extraction (2).

2. Dispositif de mesure de distance selon la revendication 1, **caractérisé en ce que** la ligne de mesure (3) est une ligne TEM, comme par exemple une ligne coaxiale.

3. Dispositif de mesure de distance selon la revendication 2, **caractérisé en ce que** la ligne de mesure (3) fonctionne en transmission pour la détection des propriétés matérielles, et
a) est reliée par une structure d'injection à un émetteur HF (9) sur l'électronique d'évaluation, et
b) est reliée par une structure d'extraction à un récepteur HF (10) sur l'électronique d'évaluation.

4. Dispositif de mesure de distance selon la revendication 2, **caractérisé en ce que** la ligne de mesure (3) fonctionne en réflexion pour la détection des propriétés matérielles, et
a) est reliée par un coupleur directif (8) à un émetteur HF (9) et à un récepteur HF (10) sur l'électronique d'évaluation, et
b) présente un point de réflexion de la ligne de mesure (3) qui est décrit de manière analytique, comme par exemple une extrémité de ligne ouverte.

5. Dispositif de mesure de distance selon la revendication 3 ou 4, **caractérisé en ce que** par l'intermédiaire du récepteur HF (10) et de l'émetteur HF (9) reliés à la ligne de mesure (3), on mesure la phase qui correspond à la longueur électrique de la ligne de mesure (3) y compris la longueur électrique des lignes d'alimentation et des composants passifs.

6. Procédé permettant d'établir une distance en utilisant un dispositif de mesure de distance entre un corps réfléchissant (5) et une structure conductrice (4) présentant un milieu et une zone d'injection pour des ondes électromagnétiques, prévue à une partie d'extrémité de la structure conductrice, présentant les étapes de procédé suivantes consistant à :
a) établir la permittivité relative du milieu dans la structure conductrice à l'aide d'une ligne de mesure (3) pour la détection des propriétés matérielles du milieu, dans lequel la ligne de mesure (3) est prévue dans la zone d'injection de la structure conductrice et présente un point d'injection et d'extraction (2),
b) injecter une onde électromagnétique dans la structure conductrice par l'intermédiaire d'une jonction de ligne (1) au niveau de la zone d'injection,
c) extraire l'onde électromagnétique réfléchie au niveau du corps réfléchissant de la structure conductrice par l'intermédiaire de la jonction de ligne (1), et
d) établir la distance entre la zone d'injection et le corps réfléchissant à partir de la différence de phase entre le signal d'émission et de réception et les longueurs électriques associées dans la structure conductrice entre l'onde électromagnétique injectée et l'onde électromagnétique extraite.

7. Procédé selon la revendication 6, **caractérisé en ce que** pour l'établissement de la distance à l'aide de la différence de phase entre le signal d'émission et le signal de réception, on dispose d'informations concernant la différence de phase, la distance et les propriétés diélectriques par l'intermédiaire d'une mesure d'étalonnage et en utilisant un système de mesure supplémentaire comme grandeur de référence.

8. Procédé selon la revendication 6, **caractérisé en ce que** la permittivité relative est établie pour une fréquence ou plus dans un procédé de duplex par répartition dans le temps ou de fréquence et est précisée en calculant la moyenne des résultats à différentes fréquences.

9. Procédé selon la revendication 6, **caractérisé en ce que** la ligne de mesure (3) est découplée de la structure conductrice pour les fréquences respectivement excitées en vue de la mesure de distance.

10. Procédé permettant d'établir une distance entre un corps réfléchissant (5) dans une structure conductrice (4) et une zone d'injection pour des ondes électromagnétiques, prévue à une partie d'extrémité de la structure conductrice, comprenant les étapes de procédé consistant à :
a) établir la permittivité relative d'un milieu dans la structure conductrice à l'aide d'une ligne de mesure (3) pour détecter des propriétés matérielles du milieu, dans lequel la ligne de mesure (3) est prévue dans la zone d'injection de la structure conductrice et présentant un point d'injection et d'extraction (2),
b) injecter une onde électromagnétique dans la structure conductrice par l'intermédiaire d'une jonction de ligne (1) au niveau de la zone d'injection,
c) extraire de la structure conductrice l'onde électromagnétique réfléchie au niveau du corps réfléchissant par l'intermédiaire de la jonction de ligne (1), et
d) mesurer les phases et la relation d'amplitude à l'aide d'une électronique d'évaluation, et déterminer un facteur de réflexion complexe,
e) établir la distance entre la zone d'injection et le corps réfléchissant à l'aide des longueurs d'onde de l'onde électromagnétique, déterminées par l'intermédiaire des propriétés diélectriques, dans une ligne dispersive et des relations de phase d'un bloc de paramètres S extrait de la structure conductrice en tenant compte de l'ambigüité n^{∗}2^{∗}PI de la phase de l'onde électromagnétique.

11. Procédé selon la revendication 10, qui présente en outre l'étape consistant à : extraire par le facteur de réflexion complexe mesuré le bloc de paramètres S, le bloc de paramètres S représentant une ligne de mesure pour mesurer la distance, en désincorporant le bloc de paramètres S qui représente des composants actifs et passifs avant l'injection et après l'extraction de l'onde électromagnétique.

12. Procédé selon l'une quelconque des revendications 10 ou 11, présentant en outre les étapes consistant à :
établir les propriétés diélectriques d'un milieu, ou la permittivité relative à partir de la réponse en fréquence dispersive, dépendant des propriétés diélectriques, de la longueur d'onde dans la structure conductrice, à l'aide d'un bloc de paramètres S extrait de composants avant et au moment de l'injection dans la structure conductrice et en tenant compte d'une phase ambiguë n*2*PI du bloc de paramètres S extrait.

13. Procédé selon la revendication 10, **caractérisé en ce que** le bloc de paramètres S est déterminé par une recherche de paramètre à l'aide d'une minimisation des erreurs en modélisant une ligne de mesure idéale pour la mesure de distance, d'une information de référence de distance et des valeurs de mesure de l'unité d'évaluation du facteur de réflexion complexe pour 2 positions de mesure ou plus et pour 2 fréquences ou plus.
